(19) Europäisches Patentamt
European Patent Office
Office européen des brevets

(11) **EP 2 392 510 B1**

(12) **FASCICULE DE BREVET EUROPEEN**

(45) Date de publication et mention
de la délivrance du brevet:
**06.11.2013 Bulletin 2013/45**

(51) Int Cl.:
*B64D 45/00* (2006.01)  *G01R 33/07* (2006.01)
*G01D 5/14* (2006.01)  *G01B 7/14* (2006.01)

(21) Numéro de dépôt: **11168353.8**

(22) Date de dépôt: **01.06.2011**

(54) **Système de détection du désalignement de surfaces portantes pour aéronef**

Sytem zur Erkennung einer Schieflage einer Flugzeugauftriebsfläche

Skew detection system for aircraft lifting surfaces

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **04.06.2010 BE 201000338**

(43) Date de publication de la demande:
**07.12.2011 Bulletin 2011/49**

(73) Titulaire: **Sonaca S.A.
6041 Gosselies (BE)**

(72) Inventeurs:
• **Deplaen, Didier
1150 Bruxelles (BE)**
• **Heusdens, Bruno
4458 Fexhe-Slins (BE)**
• **Dupont, François
4000 Liège (BE)**
• **Saint-Mard, Michel
4602 Cheratte (BE)**

(74) Mandataire: **Ilgart, Jean-Christophe
BREVALEX
95 rue d'Amsterdam
75378 Paris Cedex 8 (FR)**

(56) Documents cités:
EP-A1- 0 726 201    US-A- 5 680 124
US-A1- 2008 278 148    US-A1- 2009 009 273
US-B1- 6 483 436

**Description**

**DOMAINE TECHNIQUE**

L'invention se rapporte à la détection d'un défaut d'actionnement de surfaces de vol mobiles, appelés volets (en anglais « slats » ou « flaps »).

Le système doit être capable de détecter un défaut d'actionnement entraînant un désalignement anormal entre deux surfaces de vol adjacentes. L'alerte doit être déclenchée lorsque le désalignement dépasse la valeur de consigne du système. Cette valeur de consigne est fixée pour chaque configuration d'application.

**ÉTAT DE LA TECHNIQUE ANTÉRIEURE**

Les surfaces de vol sont montées sur des supports, constitués de rails, reliés à la partie fixe de l'aile par un mécanisme à rouleaux permettant les mouvements d'entrée/sortie des volets.

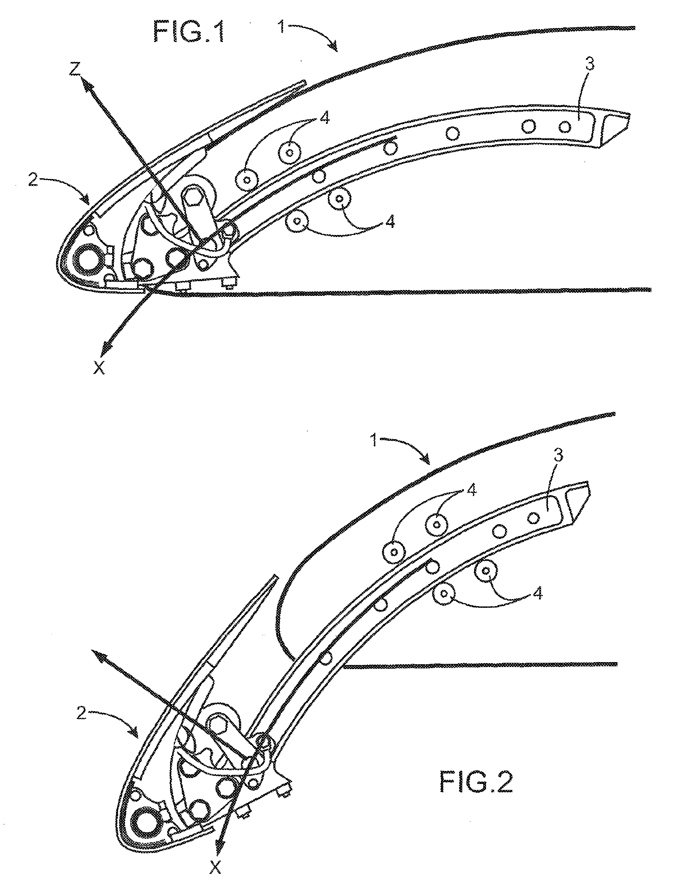

La figure 1 est une vue en coupe d'une aile d'avion 1 montrant un volet 2 en position rétractée. La figure montre également un support ou rail 3 qui peut être déplacé selon un trajet défini par des rouleaux 4. Le volet 2 est fixé à l'une des extrémités du support 3. On définit, sur cette figure, un axe X qui est l'axe d'actionnement du volet et un axe en élévation Z.

La figure 2 est une vue en coupe de l'aile d'avion 1 montrant le volet 2 en position sortie. Un troisième axe, l'axe Y ou axe longitudinal (selon la longueur de l'aile), non montré sur les figures 1 et 2, est perpendiculaire au plan de ces figures.

En fonctionnement normal, les surfaces de vols subissent plusieurs effets pouvant générer des mouvements relatifs. Ces mouvements sont considérés comme acceptables et ne doivent pas générer d'alerte.

L'augmentation de la température de la structure de l'aile, induite par le système de dégivrage de l'avion, provoque la dilatation des volets. Cette dilatation provoque un rapprochement des nervures externes de deux volets adjacents (déplacement selon l'axe Y). A l'inverse, la contraction de la structure des surfaces de vol aux basses températures entraîne un éloignement des nervures externes de deux volets adjacents.

La combinaison des jeux et tolérances de fabrication peut également générer des configurations où une surface de vol sera positionnée avec une certaine élévation par rapport à la surface adjacente (déplacements suivant l'axe Z).

Les vibrations auxquelles sont soumises les structures des surfaces de vol peuvent également entraîner certains mouvements relatifs (déplacements combinés suivant les axes X, Y et Z).

En cas de panne du système d'actionnement, le désalignement génère des mouvements relatifs spécifiques, suivant l'axe X, qui doivent, eux, être détectés par le système.

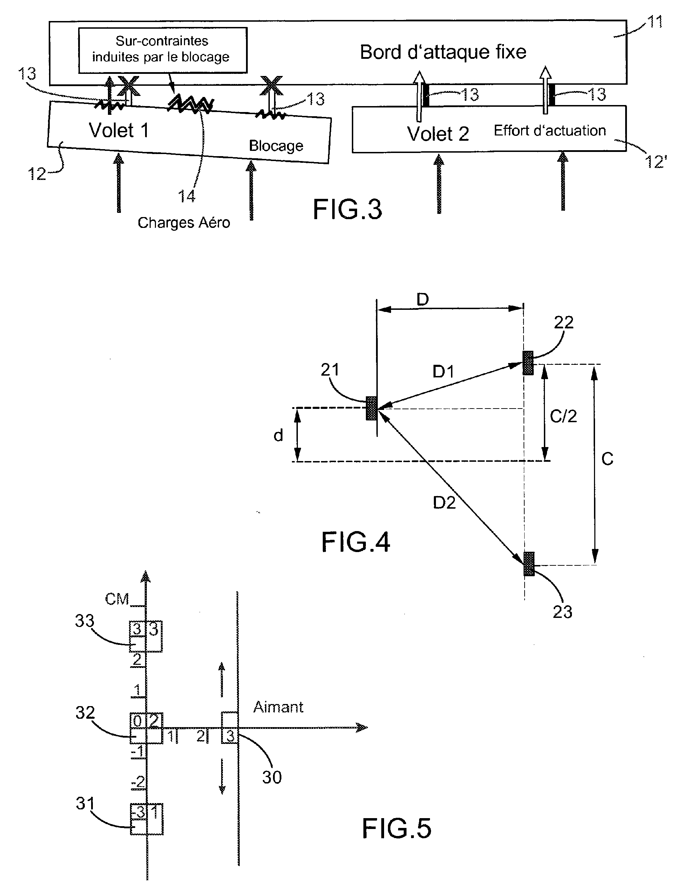

Si le blocage d'un support se produit lors d'une phase d'extension ou de rétraction, et si ce blocage n'est pas détecté, le mécanisme d'actuation, qui continue d'entraîner les autres supports, génère une torsion de la surface de vol qui entraîne une augmentation importante des contraintes dans la structure à certains endroits. Ceci est illustré par la figure 3 qui montre, de manière schématique, un exemple de panne d'actionnement lors de la rétraction des volets. La référence 11 désigne le bord d'attaque fixe de l'aile. La référence 12 désigne un premier volet actionné par des supports ou rails 13. La référence 12' désigne un deuxième volet actionné par d'autres supports ou rails 13. La figure montre que, lors de la manoeuvre de rétraction du volet 12, un blocage de l'un des rails s'est produit, blocage figuré par une croix. La référence 14 désigne des contraintes supplémentaires induites par le blocage et qui s'exercent sur le volet 12. Les flèches représentent les charges aérodynamiques appliquées sur les volets 12 et 12' et sur le bord d'attaque fixe 11.

En l'absence de système de détection, ces sur-contraintes doivent être prises en compte dans le dimensionnement de la structure. Il en résulte une augmentation de la masse de celle-ci.

Le document EP-A-1 175 339 divulgue une pale de rotor d'hélicoptère comprenant un volet monté de manière articulée sur un bord de fuite de la pale, un dispositif de mesure d'angle de volet étant monté sur la pale de rotor pour détecter la position angulaire du volet par rapport au bord de fuite. Ce dispositif comprend un capteur à effet Hall monté sur le bord de fuite de la pale et comportant une face de détection. Le dispositif comprend également un élément magnétique monté sur le volet et dont l'axe polaire est positionné parallèlement à la face de détection du capteur à effet Hall.

Le document US-A-6 483 436, qui représente l'art antérieur le plus proche, divulgue un dispositif de détection du désalignement de deux volets adjacents. Ce dispositif est monté à cheval sur les deux volets. Il comprend une première partie fixée à l'un des volets et une deuxième partie constituée de deux branches parallèles venant en affleurement au-dessus de l'autre volet. Un ergot, solidaire de ce dernier volet, est positionné entre les deux branches. Les extrémités des deux branches se font face et comprennent, l'une un capteur et l'autre une cible coopérant pour fournir un signal. Les deux branches sont reliées, à peu près dans la zone séparant les deux volets, par une plaquette métallique appelée « fusible métallique ». Lors d'un actionnement normal des volets, les deux volets se déplacent de manière synchronisée. Les positions relatives des deux branches du dispositif de détection et de l'ergot ne varient pas, l'ergot restant positionné à égale distance des deux branches. Lorsqu'un désalignement se produit, l'ergot se rapproche de l'une des deux branches jusqu'à venir en contact et appuyer sur celle-ci. Il en résulte une rupture de la plaquette fusible. Lorsque la plaquette est rompue, un ressort écarte les deux branches et les maintient en position ouverte. Dans cette configuration, la cible n'est plus positionnée en face du capteur, ce qui déclenche une alarme qui est transmise au système de contrôle de l'actionnement. Ce dispositif présente plusieurs inconvénients. Il délivre un signal binaire qui ne permet pas une prise de mesure progressive du désalignement. Il présente une mauvaise fiabilité en service avec comme conséquences de nombreux cas de fausses pannes et, dès lors des immobilisations d'avions intempestives. Il est impossible de ré-initialiser le système, puisque le fusible électrique est rompu et qu'il faut le remplacer. Enfin, ce dispositif est peu compact.

## EXPOSÉ DE L'INVENTION

La présente invention a été conçue pour remédier aux inconvénients de l'art antérieur mentionnés ci-dessus.

Elle propose un système de détection efficace, qui peut être couplé au dispositif d'actionnement des volets et permettant de commander l'arrêt immédiat de ce dispositif lorsqu'un désalignement des volets est détecté. Ce système permet de protéger la structure supportant les volets contre les sur-contraintes. Ainsi les sur-contraintes ne doivent plus être prises en compte dans le dimensionnement de cette structure.

L'invention a donc pour objet un système de détection du désalignement de volets de surfaces portantes pour un aéronef, les volets étant montés de manière articulée par rapport au reste des surfaces portantes et étant constitués d'au moins deux volets adjacents, les deux volets adjacents pouvant être actionnés pour être déplacés simultanément d'une première position, ou position rétractée, à une seconde position, ou position sortie, et inversement, le système de détection comprenant des premiers moyens montés sur l'un des deux volets adjacents et des deuxièmes moyens montés sur l'autre des deux volets adjacents, les premiers moyens et les deuxièmes moyens étant disposés en vis-à-vis et coopérant pour déclencher une alarme à partir d'un désalignement déterminé des deux volets adjacents, caractérisé en ce que les premiers moyens comprennent un aimant, les deuxièmes moyens comprennent au moins deux capteurs magnétiques délivrant chacun un signal électrique, représentatif de leur position relative par rapport à l'aimant, à des moyens de traitement électronique fournissant un signal d'alarme lorsque le désalignement déterminé est atteint.

Le système peut comprendre deux capteurs disposés à égale distance de l'aimant lorsque les volets sont en position rétractée et selon l'axe d'actionnement des volets.

Le système peut avantageusement comprendre trois capteurs, un capteur, dit capteur central, étant disposé en vis-à-vis de l'aimant, les deux autres capteurs, dit capteurs latéraux, étant situés à égale distance du capteur central, les capteurs étant alignés selon l'axe d'actionnement des volets. Selon un mode préféré de mise en oeuvre, la distance séparant chaque capteur latéral du capteur central est le double de la valeur du désalignement déterminé.

Pour un système de détection à trois capteurs, les moyens de traitement électronique peuvent comprendre :

- un premier comparateur recevant sur l'une de ses entrées le signal électrique délivré par le capteur central et sur l'autre de ses entrées le signal électrique délivré par l'un des capteurs latéraux,
- un deuxième comparateur recevant sur l'une de ses entrées le signal électrique délivré par le capteur central et sur l'autre de ses entrées le signal électrique délivré par l'autre capteur latéral,
- au moins deux multiplexeurs destinés à router sur la sortie du système un signal spécifique correspondant soit à une situation normale, soit à une situation d'alerte, les multiplexeurs étant commandés par les sorties des deux comparateurs ainsi que par d'éventuels signaux provenant de dispositifs d'auto-test.

Ils peuvent aussi comprendre un composant de type microcontrôleur à plusieurs entrées, une première entrée recevant le signal électrique délivré par l'un des capteurs latéraux, une deuxième entrée recevant le signal électrique délivré par le capteur central et une troisième entrée recevant le signal électrique délivré par l'autre capteur latéral, la sortie du micro-contrôleur étant connectée à un BUS Numérique destiné à transmettre un signal proportionnel au désalignement.

## BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels .

- La figure 1 est une vue en coupe d'une aile d'avion montrant un volet en position rétractée,
- la figure 2 est une vue en coupe d'une aile d'avion montrant le volet en position sortie,
- la figure 3 est un schéma illustrant un exemple de panne d'actionnement lors de la rétraction de volets,
- la figure 4 est un schéma explicatif illustrant une solution à deux capteurs,
- la figure 5 est un schéma illustrant une solution à trois capteurs,
- les figures 6, 7 et 8 sont des diagrammes montrant la tension de sortie de chacun des capteurs du système de détection de la figure 5 en fonction de la distance séparant la cible de chacun des capteurs,
- la figure 9 représente un circuit électronique permettant de traiter et de transmettre un signal d'alerte,
- la figure 10 est un schéma d'alerte entre 0 et 10 volts,
- la figure 11 représente un autre circuit électronique permettant de traiter et de transmettre un signal d'alerte.

## EXPOSÉ DÉTAILLÉ DE MODES DE RÉALISATION PARTICULIERS DE L'INVENTION

Le système de détection selon l'invention est constitué d'un ensemble de capteurs montés sur la nervure externe d'une surface de vol et d'une cible montée sur la nervure externe de la surface de vol adjacente, ces surfaces de vol se faisant face. Les capteurs détectent la proximité de la cible et la variation de la position de la cible et de la distance entre la cible et l'ensemble de capteurs.

La cible est constituée par un aimant. Avantageusement, on utilisera un aimant au néodyme-fer-bore. Les aimants au néodyme-fer-bore sont parmi les plus puissants. Ils permettront au capteur de présenter un signal de sortie maximal. De plus, ces aimants tiennent au minimum à une température de 80°C.

Parmi les capteurs de proximité les capteurs magnétiques sont intéressants pour les raisons suivantes. L'utilisation d'un émetteur actif, tel qu'un aimant, permet d'obtenir une portée bien supérieure à la portée des systèmes passifs (c'est-à-dire les systèmes inductifs ou capacitifs), et cela avec des capteurs de dimensions inférieures. Le système de détection sera aussi moins sensible aux conditions environnementales (températures, poussières...) que pour les autres types de capteur.

Il existe principalement deux types de capteurs de proximité magnétique : les capteurs à effet Hall et les capteurs à résistance variable en fonction du champ magnétique. Pour l'application envisagée, ce sont les capteurs à effets Hall qui ont été sélectionnés.

Un capteur à effet Hall est généralement constitué d'un conducteur ou semiconducteur « rectangulaire », soumis à une différence de potentiel. Un champ magnétique a pour effet de dévier la trajectoire des électrons qui traversent le capteur et de faire apparaître une différence de potentiel entre ses faces latérales. Cette différence de potentiel dépend de l'intensité du champ et de sa direction.

Pour obtenir une discrimination entre mouvements normaux et anormaux des surfaces portantes, le système de détection met en oeuvre au moins deux capteurs. On va montrer qu'un système à trois capteurs est optimal.

La figure 4 est un schéma explicatif illustrant une solution à deux capteurs. Sur ce schéma, la référence 21 représente la cible (un aimant), la référence 22 représente un premier capteur de détection magnétique et la référence 23 représente un deuxième capteur de détection magnétique. Le schéma montre une situation de désalignement d indépendante de l'éloignement « spanwise » (suivant l'axe Y). On appelle C la distance entre les deux capteurs 22 et 23, D la distance entre la cible 21 et le plan passant par les deux capteurs 22 et 23, D1 la distance séparant la cible 21 et le capteur 22 et D2 la distance séparant la cible 21 et le capteur 23. En situation d'alignement, la cible 21 est située sur la perpendiculaire au plan passant par les deux capteurs et située à une distance C/2 de chaque capteur.

Comme les valeurs de D1 et D2 peuvent être connues à partir du signal émis par les deux capteurs, on peut déterminer la valeur de d à partir de :

$$D1^2 = \left[\left(\frac{C}{2}\right) - d\right]^2 + D^2 \quad \text{et} \quad D2^2 = \left[\left(\frac{C}{2}\right) + d\right]^2 + D^2$$

Ce qui donné :

$$d = \frac{D2^2 - D1^2}{2C}$$

Remarque : Le schéma de la figure 1 n'est pas dessiné dans le plan horizontal mais bien dans le plan défini par les deux capteurs et la cible, indépendamment de l'élévation (Z) de celle-ci. Les calculs restent donc valables pour des configurations où l'élévation de la cible n'est pas nulle.

Il est donc théoriquement possible d'obtenir un système d'alerte indépendant de l'élévation (Z) et de l'éloignement (Y), ceci pour autant que la distance cible/capteur puisse être déduite de la réponse des capteurs, ce qui nécessite une calibration détaillée du système pour toutes les positions de cible envisagées.

Par ailleurs, il est également possible d'en déduire la valeur de D, soit :

$$D = \sqrt{\left(\frac{D1^2 + D2^2}{2}\right) - \frac{C^2}{4} - d^2}$$

et dès lors d'affiner les valeurs de D1 et D2 en fonction de D en quelques itérations.

Les calculs montrent que le système bi-capteur nécessitera :

- une calibration du système pour déterminer la fonction de réponse du capteur, soit D = f(Sc) où Sc est le signal du capteur,
- l'utilisation d'un microcontrôleur pour que le système fonctionne comme système d'alerte.

Les inconvénients principaux sont liés à l'utilisation des valeurs absolues des réponses des capteurs :

- un risque de perte de précision lié à la diminution de la puissance de l'aimant au cours du temps. Cette diminution entraîne une variation de la fonction de réponse du capteur et, dès lors, un changement des paramètres du système,
- une variation possible de la fonction de réponse du capteur en fonction de la température environnante et, dès lors, la nécessité d'une compensation de température.

L'utilisation de trois capteurs permet d'augmenter sensiblement la précision et la robustesse du système. En effet, la détection de désalignement est générée lorsque la cible devient plus proche d'un des deux capteurs externes que du capteur central.

Ceci permet:

- d'avoir un seuil d'alerte très précis (basé sur la différence du signal entre le capteur central et l'un des capteurs externes).
- d'avoir un seuil d'alerte indépendant de l'éloignement « spanwise » (Y) entre la cible et les capteurs.
- d'avoir une compensation automatique des variations de température et de puissance de l'aimant.

La figure 5 est un schéma illustrant une solution à trois capteurs. Le schéma montre le système en position d'alignement. Les axes des abscisses et des ordonnées sont gradués en cm. L'aimant 30 est situé à 3 cm du plan contenant les capteurs 31, 32 et 33. Le capteur 31 est situé à 3 cm du capteur 32 et le capteur 33 est situé à 3 cm du capteur 32.

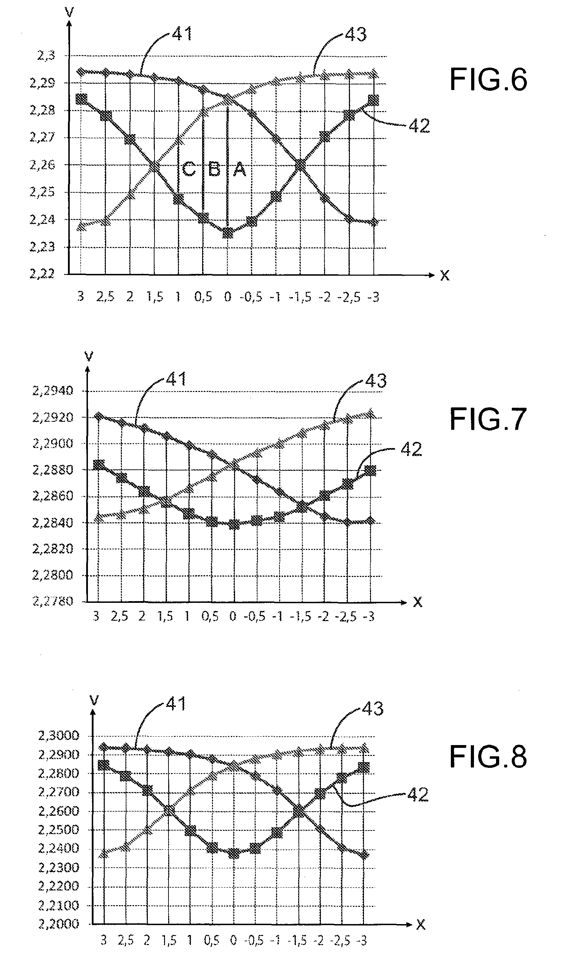

Les figures 6, 7 et 8 sont des diagrammes montrant la tension de sortie V (en volts) de chacun des capteurs du système de détection de la figure 5 en fonction de la distance x séparant la cible de chacun des capteurs. Le diagramme de la figure 6 montre des courbes tracées pour un aimant 30 placé à 3 cm du plan contenant les capteurs 31, 32 et 33. La courbe 41 correspond au capteur 31, la courbe 42 correspond au capteur 32 et la courbe 43 correspond au capteur 33. Le diagramme de la figure 7 montre des courbes tracées pour un aimant 30 placé à 6 cm du plan contenant les capteurs 31, 32 et 33. Le diagramme de la figure 8 montre des courbes tracées pour un aimant 30 placé à 1 cm du plan contenant les capteurs 31, 32 et 33.

Un système de détection à deux capteurs demande un traitement du signal complexe et nécessite un micro-contrôleur tandis qu'un système de détection à trois capteurs nécessite un traitement de signal simple et analogique.

Dans le système de détection représenté schématiquement sur la figure 5, les trois capteurs 31, 32 et 33 sont placés sur une surface de vol et l'aimant 30 est placé sur la surface de vol adjacente. En position « normale », l'aimant 30 se situe en face du capteur central 32, tant en configuration sortie que rétractée. Il est judicieux de laisser un écart suffisant (par exemple 3 cm) entre le plan des capteurs et l'aimant afin qu'ils n'entrent pas en contact lors des mouvements longitudinaux (selon l'axe Y). Ceci implique d'utiliser un capteur dit « longue portée ».

Lorsqu'un désalignement apparaît, la symétrie dans le positionnement des composants du système de détection disparaît et le signal du capteur central va progressivement diminuer au profit du signal d'un des capteurs latéraux (trois capteurs permettent de détecter un désalignement dans les deux sens).

Ce système comporte un gros avantage par rapport à un système n'utilisant qu'un seul capteur. En effet, les mouvements longitudinaux (selon l'axe Y) ne doivent pas générer d'alerte. Or, en n'utilisant qu'un seul capteur, il ne sera pas possible de différencier une diminution du signal due à un éloignement capteur-cible selon l'axe longitudinal par rapport à une diminution due à un éloignement dans le sens de l'actuation (axe X). Il serait donc difficile de fixer le seuil de décision.

En utilisant trois capteurs, les déplacements longitudinaux donnent lieu à une variation similaire du signal pour les trois capteurs alors que ce n'est pas le cas pour les déplacements suivant l'axe X. Ceci permet de différencier les déplacements en étudiant les signaux relatifs des trois capteurs.

Le système de détection selon l'invention permet la génération d'une alerte. La méthode la plus simple pour utiliser ce dispositif est d'écarter les capteurs du double du désalignement autorisé, Par exemple, si l'on veut détecter un désalignement de 15 mm, il faut séparer les capteurs de 30 mm. Ainsi, l'alerte est générée dès que le signal d'un des capteurs latéraux dépasse celui donné par le capteur central, ce qui se produit lorsque le désalignement est égal à la moitié de la distance séparant les capteurs.

Il est également possible, avec les variations des signaux des capteurs, de générer une mesure proportionnelle au désalignement. Ceci permet, pour des valeurs de désalignement inférieures au seuil d'alerte, d'enregistrer l'évolution du désalignement au cours de la vie de l'avion. Ces mesures peuvent alors être utilisées en maintenance prédictive pour détecter une dérive de l'actuation, par exemple suite à l'augmentation des jeux dans le mécanisme ou l'apparition de grippage dans le mécanisme, et d'effectuer les actions correctrices préventivement.

L'électronique du système de détection peut être adaptée pour traiter à la fois un signal d'alerte et un signal proportionnel au désalignement.

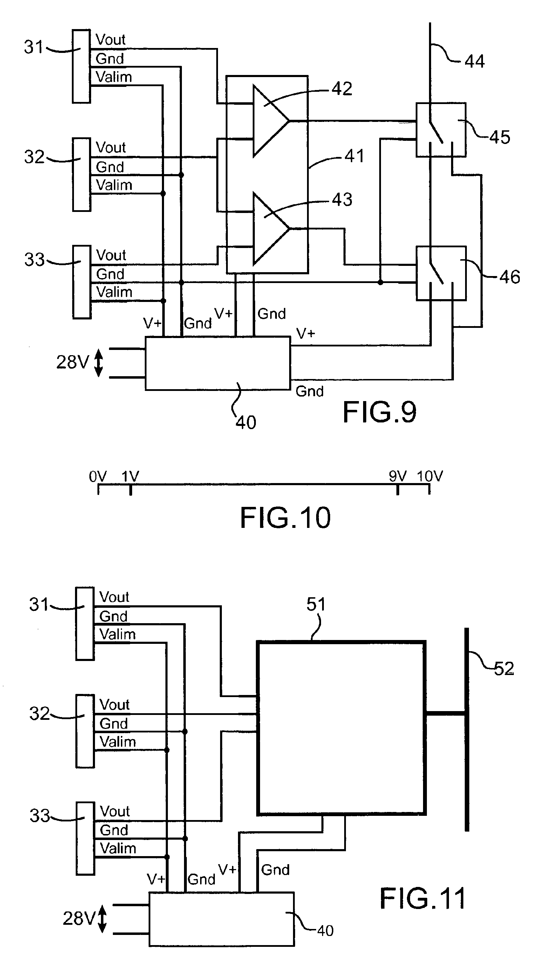

La figure 9 représente un circuit électronique permettant de traiter et de transmettre un signal d'alerte. Cette figure montre les trois capteurs 31, 32 et 33 du système de protection et leurs connexions électriques. La référence 40 représente un bloc d'alimentation électrique, alimenté sous une tension continue de 28 volts, délivrant une première tension continue aux capteurs 31, 32 et 33 et une deuxième tension continue à une unité de comparaison 41. Chaque capteur est alimenté par une tension continue de valeur appropriée, reçue sur leurs entrées Valim et Gnd, fournie par le bloc d'alimentation 40. L'unité de comparaison 41 comprend un premier comparateur 42 et un deuxième comparateur 43. Le comparateur 42 reçoit sur ses entrées les signaux de sortie Vout des capteurs 31 et 32. Le comparateur 43 reçoit sur ses entrées les signaux de sortie Vout des capteurs 32 et 33. La référence 44 représente un conducteur électrique sur lequel sont branchés en série deux multiplexeurs électroniques 45 et 46. L'entrée du multiplexeur 45 reçoit le signal présent entre la sortie du comparateur 42 et la masse Gnd. L'entrée du multiplexeur 46 reçoit le signal présent entre la sortie du comparateur 43 et la masse Gnd. Des signaux de désalignement significatifs provoqueront le basculement soit du multiplexeur 45, soit du multiplexeur 46, entraînant un changement du niveau de tension sur le conducteur 44, ce qui tiendra lieu d'alerte. Ce niveau de tension peut, par exemple, commander un relais bloquant l'actionnement des volets.

A titre d'exemple, l'unité de comparaison 41 peut être le circuit dénommé Comparator AD 790 fabriqué par Analog Devices. Les multiplexeurs 45 et 46 peuvent être ceux dénommés Multiplexers/Switches MAX4560.

On peut également opter pour un système qui fournit un signal continu représentatif du désalignement. Dans ce cas, on peut préférer avoir recours à une unité de calcul. En effet, cela permet d'enregistrer la valeur initiale/normale de la différence entre le signal du capteur central et celui des capteurs latéraux et de la comparer avec la différence de ces mêmes signaux, modifiée à cause du désalignement.

On considère qu'il n'y a pas de mouvement « spanwise » qui se produit pendant la phase d'extension/rétraction des volets, cette action se déroulant sur une courte période. Cela ne pose pas de problème dans le cas d'une mesure marche/arrêt puisque l'éloignement des capteurs par rapport à l'aimant ne modifie pas le point de croisement des signaux des capteurs. Cependant, lors d'un désalignement et dans le cas d'une mesure continue, si un mouvement « spanwise » se superpose au mouvement « chordwise » de désalignement, on ne pourra pas déterminer l'impact de l'un et de l'autre sur la diminution de la différence des signaux par rapport à la position initiale.

Un premier cas est celui où le signal de sortie du système est analogique. Il est possible de représenter le désalignement par un signal de tension entre 0 volt et 10 volts. Comme le sens du désalignement ne présente pas d'intérêt, le système peut avoir le même comportement dans les deux sens. La figure 10 représente une configuration possible pour une tension dite normale (1 volt) et une tension dite alerte (9 volts). L'utilisation d'un microcontrôleur, ou de toute autre unité de calcul numérique, implique une conversion analogique-digitale suivie, dans le cas présent, d'une conversion digitale-analogique.

Un deuxième cas est celui où le signal de sortie du système est numérique. Vu que les calculs à effectuer sur les signaux nécessitent une conversion vers le numérique, il semble intéressant que le système transmette l'information de manière numérique. Le moyen le plus adapté pour transmettre cette information est le BUS Numérique.

Ce deuxième cas est illustré par la figure 11 qui représente un schéma électrique. Sur ce schéma, les mêmes références qu'à la figure 9 désignent les mêmes éléments. La référence 51 désigne un microcontrôleur alimenté en tension par le bloc d'alimentation 40 et recevant sur ses entrées les sorties Vout des capteurs 31, 32 et 30. La sortie du microcontrôleur 51 est reliée au bus CAN 52. Certains microcontrôleurs permettent une connexion directe sur un bus CAN sans avoir à utiliser de composants supplémentaires. Dans le cas présent également, le nombre de composants ne serait pas très important : régulateur de tension, microcontrôleur et composants associés.

L'utilisation d'un contrôleur peut compliquer le processus de certification du système final. En effet, le software, en plus du hardware, doit également être certifié et répondre à des critères stricts. Une solution pour remédier à ce problème est d'utiliser en parallèle un système d'alerte purement analogique et un système en continu avec microcontrôleur. Le système analogique serait chargé de donner l'alerte (arrêter la course des volets) des que l'on dépasse le seuil déterminé par la moitié de l'écartement des capteurs. Son importance serait donc critique. Le système numérique, lui, servirait au « health monitoring » (surveillance de l'état de santé), en réalisant des mesures continues et en enregistrant les données correspondantes à chaque sortie de volet. Ce système n'interviendrait en aucun cas sur l'alerte, mais permettrait de se rendre compte, au fil du temps, de l'apparition d'éventuels défauts (inférieurs au seuil critique) dans la sortie des volets. Etant donné que la partie software ne serait pas dans ce cas liée à la sécurité du vol, les requis de sa certification pourraient en être moins contraignants.

## Revendications

1. Système de détection du désalignement de volets de surfaces portantes pour un aéronef, les volets étant montés de manière articulée par rapport au reste des surfaces portantes et étant constitués d'au moins deux volets adjacents, les deux volets adjacents pouvant être actionnés pour être déplacés simultanément d'une première position, ou position rétractée, à une seconde position, ou position sortie, et inversement, le système de détection comprenant des premiers moyens aptes à être montés sur l'un des deux volets adjacents et des deuxièmes moyens aptes à être montés sur l'autre des deux volets adjacents, les premiers moyens et les deuxièmes moyens étant disposés en vis-à-vis et coopérant pour déclencher une alarme à partir d'un désalignement déterminé des deux volets adjacents, et dont les premiers moyens comprennent un aimant (21 ; 30), les deuxièmes moyens comprennent au moins deux capteurs magnétiques (22, 23 ; 31, 32, 33) délivrant chacun un signal électrique, représentatif de leur position relative par rapport à l'aimant, à des moyens de traitement électronique fournissant un signal d'alarme lorsque le désalignement déterminé est atteint.

2. Système de détection selon la revendication 1, dans lequel l'aimant (21 ; 30) est un aimant au néodyme-fer-bore.

3. Système de détection selon l'une des revendications 1 ou 2, dans lequel les capteurs (22, 23 ; 31, 32, 33) sont des capteurs à effet Hall.

4. Système de détection selon l'une quelconque des revendications 1 à 3, comprenant deux capteurs (22, 23) disposés à égale distance de l'aimant (21) lorsque les volets sont en position rétractée et selon l'axe d'actionnement des volets.

5. Système de détection selon l'une quelconque des revendications 1 à 3, comprenant trois capteurs, un capteur, dit capteur central (32), étant disposé en vis-à-vis de l'aimant (30), les deux autres capteurs, dit capteurs latéraux (31, 33), étant situés à égale distance du capteur central (32), les capteurs étant alignés selon l'axe d'actionnement des volets.

6. Système de détection selon la revendication 5, dans lequel la distance séparant chaque capteur latéral (31, 33) du capteur central (32) est le double de la valeur du désalignement déterminé.

7. Système de détection selon l'une des revendications 5 ou 6, dans lequel les moyens de traitement électronique comprennent :

   - un premier comparateur (42) recevant sur l'une de ses entrées le signal électrique délivré par le capteur central (32) et sur l'autre de ses entrées le signal électrique délivré par l'un des capteurs latéraux (31),
   - un deuxième comparateur (43) recevant sur l'une de ses entrées le signal électrique délivré par le capteur central (32) et sur l'autre de ses entrées le signal électrique délivré par l'autre capteur latéral (33),
   - au moins deux multiplexeurs destinés à router sur la sortie du système un signal spécifique correspondant soit à une situation normale, soit à une situation d'alerte, les multiplexeurs étant commandés par les sorties des deux comparateurs ainsi que par d'éventuels signaux provenant de dispositifs d'auto-test.

8. Système de détection selon l'une des revendications 5 ou 6, dans lequel les moyens de traitement électronique comprennent un composant de type microcontrôleur à plusieurs entrées, une première entrée recevant le signal électrique délivré par l'un des capteurs latéraux (31), une deuxième entrée recevant le signal électrique délivré par le capteur central (32) et une troisième entrée recevant le signal électrique délivré par l'autre capteur latéral (33), la sortie du micro-contrôleur étant connectée à un BUS Numérique (52) destiné à transmettre un signal proportionnel au désalignement.

**Patentansprüche**

1. System zur Detektion einer Fehlausrichtung von Tragflächenklappen für ein Luftfahrzeug, wobei die Klappen in Bezug auf den Rest der Tragflächen verstellbar angebracht sind und aus mindestens zwei nebeneinanderliegenden Klappen bestehen, wobei die beiden nebeneinanderliegenden Klappen derart betätigt werden können, dass sie gleichzeitig aus einer ersten Position, oder eingefahrenen Position, in eine zweite Position, oder ausgefahrene Position, und umgekehrt gebracht werden können, wobei das System zur Detektion erste Mittel, die an einer der beiden nebeneinanderliegenden Klappen angebracht werden können, und zweite Mittel, die an der anderen der beiden nebeneinanderliegenden Klappen angebracht werden können, umfasst, wobei die ersten Mittel und die zweiten Mittel gegenüberliegend angeordnet sind und derart zusammenwirken, dass sie aufgrund einer vorgegebenen Fehlausrichtung der beiden nebeneinanderliegenden Klappen einen Alarm auslösen, und wobei die ersten Mittel einen Magneten (21, 30) umfassen, die zweiten Mittel mindestens zwei Magnetfühler (22, 23; 31, 32, 33) aufweisen, die jeweils ein elektrisches Signal, das ihre relative Position in Bezug auf den Magneten darstellt, an Mittel zur elektronischen Behandlung liefern, die ein Alarmsignal liefern, sobald die vorgegebene Fehlausrichtung erreicht ist.

2. System zur Detektion nach Anspruch 1, wobei der Magnet (21, 30) ein Magnet aus Neodym-Eisen-Bor ist.

3. System zur Detektion nach einem der Ansprüche 1 oder 2, wobei die Fühler (22, 23; 31, 32, 33) Hall-Effekt-Sensoren sind.

4. System zur Detektion nach einem der Ansprüche 1 bis 3, das zwei Fühler (22, 23) umfasst, die, wenn sich die Klappen in eingefahrener Position befinden, im gleichen Abstand zum Magneten und längs der Betätigungsachse der Klappen angeordnet sind.

5. System zur Detektion nach einem der Ansprüche 1 bis 3, das drei Fühler umfasst, wobei ein Fühler, der als Zentralfühler (32) bezeichnet wird, gegenüber dem Magneten (30) angeordnet ist, die beiden anderen Fühler, die als Seitenfühler (31, 33) bezeichnet werden, sich in einem gleichen Abstand zum Zentralfühler (32) befinden, wobei die Fühler längs der Betätigungsachse der Klappen ausgerichtet sind.

6. System zur Detektion nach Anspruch 5, wobei der Abstand, der jeden Seitenfühler (31, 33) vom Zentralfühler (32) trennt, das Doppelte des Werts der vorgegebenen Fehlausrichtung ist.

7. System zur Detektion nach einem der Ansprüche 5 oder 6, wobei die Mittel zur elektronischen Behandlung umfassen:

   - einen ersten Komparator (42), der an dem einen seiner Eingänge das elektrische Signal, das von dem Zentralfühler (32) geliefert wird, und an dem anderen seiner Eingänge das elektrische Signal, das von einem der Seitenfühler (31) geliefert wird, empfängt,
   - einen zweiten Komparator (43), der an dem einen seiner Eingänge das elektrische Signal, das von dem Zentralfühler (32) geliefert wird, und an dem anderen seiner Eingänge das elektrische Signal, das von dem anderen Seitenfühler (33) geliefert wird, empfängt,
   - mindestens zwei Multiplexer, die dazu bestimmt sind, ein spezifisches Signal, das entweder einer normalen Situation oder einer Warnsituation entspricht, auf den Ausgang des Systems zu legen, wobei die Multiplexer durch die Ausgänge der beiden Komparatoren sowie durch mögliche Signale, die von Selbsttestvorrichtungen stammen, gesteuert werden.

8. System zur Detektion nach einem der Ansprüche 5 oder 6, wobei die Mittel zur elektronischen Behandlung eine Komponente des Mikrocontrollertyps mit mehreren Eingängen umfassen, wobei ein erster Eingang das elektrische Signal empfängt, das von einem der Seitenfühler (31) geliefert wird, ein zweiter Eingang das elektrische Signal empfängt, das von dem Zentralfühler (32) geliefert wird, und ein dritter Eingang das elektrische Signal empfängt, das von dem anderen Seitenfühler (33) geliefert wird, wobei der Ausgang des Mikrocontrollers mit einem numerischen Bus (52) verbunden ist, der dazu bestimmt ist, ein zur Fehlausrichtung proportionales Signal zu übertragen.

**Claims**

1. A skew detection system for aircraft lifting surface flaps, the flaps being mounted hinged relative to the rest of the lifting surfaces and being made up of at least two adjacent flaps, the two adjacent flaps being able to be actuated to be moved simultaneously from a first position, or retracted position, to a second position, or extended position, and vice versa, the detection system comprising first means capable of being mounted on one of the two adjacent flaps and second means capable of being mounted on the other of the two adjacent flaps, the first means and the second means being positioned opposite each other and cooperating to activate an alarm from a predetermined skew of the two adjacent flaps, and whereof the first means comprise a magnet (21; 30), the second means comprise at least two magnetic sensors (22, 23; 31, 32, 33) each delivering an electrical signal, representative of their relative position with respect to the magnet, to electronic processing means providing an alarm signal when the predetermined skew is reached.

2. The detection system according to claim 1, wherein the magnet (21; 30) is a neodyme-iron-boron magnet.

3. The detection system according to one of claims 1 or 2, wherein the sensors (22, 23; 31, 32, 33) are Hall effect sensors.

4. The detection system according to any one of claims 1 to 3, comprising two sensors (22, 23) positioned at equal distances from the magnet (21) when the flaps are in the retracted position and along the actuating axis of the flaps.

5. The detection system according to any one of claims 1 to 3, comprising three sensors, one sensor, called central sensor (32), being positioned opposite to the magnet (30), the other two sensors, called side sensors (31, 33) being situated at equal distances from the central sensor (32), the sensors being aligned along the actuating axis of the flaps.

6. The detection system according to claim 5, wherein the distance separating each side sensor (31, 33) from the central sensor (32) is twice the value of the predetermined skew.

7. The detection system according to one of claims 5 or 6, wherein the electronic processing means comprise:

    - a first comparator (42) receiving the electrical signal delivered by the central sensor (32) on one of its inputs, and on the other of its inputs, the electrical signal delivered by one of the side sensors (31),
    - a second comparator (43) receiving the electrical signal delivered by the central sensor (32) on one of its inputs, and on the other of its inputs, the electrical signal delivered by the other side sensor (33),
    - at least two multiplexers intended to route, on the output of the system, a specific signal corresponding either to a normal situation or to an alert situation, the multiplexers being commanded by the outputs of the two comparators as well as by any signals coming from self-testing devices.

8. The detection system according to one of claims 5 or 6, wherein the electronic processing means comprise a component of the microcontroller type with several inputs, a first input receiving the electrical signal delivered by one of the side sensors (31), a second input receiving the electrical signal delivered by the central sensor (32), and a third input receiving the electrical signal delivered by the other side sensor (33), the output of the microcontroller being connected to a Digital BUS (52) intended to transmit a signal proportional to the skew.

FIG.1

FIG.2

Sur-contraintes
induites par le blocage

Bord d'attaque fixe

13

Volet 1

Blocage

13

13

Volet 2

Effort d'actuation

11

12

14

Charges Aéro

**FIG.3**

12'

D

22

21

D1

d

C/2

C

D2

23

**FIG.4**

CM

33

3 3

2

1

32

0 2

Aimant

1

2

3

-1

30

-2

31

3 1

**FIG.5**

FIG.6

FIG.7

FIG.8

31 — Vout / Gnd / Valim

32 — Vout / Gnd / Valim

33 — Vout / Gnd / Valim

42

41

43

44

45

46

V+ / Gnd / V+ / Gnd / V+ / Gnd

28V

40

**FIG.9**

0V 1V — 9V 10V

**FIG.10**

31 — Vout / Gnd / Valim

32 — Vout / Gnd / Valim

33 — Vout / Gnd / Valim

51

52

V+ / Gnd / V+ / Gnd

28V

40

**FIG.11**

**EP 2 392 510 B1**